# EUROPEAN PATENT SPECIFICATION

(11) **EP 0 809 721 B1**
(45) Date of publication and mention of the grant of the patent: **23.12.1998**
(21) Application number: 96902000.7
(22) Date of filing: 12.02.1996
(51) Int. Cl.: C30B 23/02, C30B 29/02, C30B 29/04

(54) **METHOD AND APPARATUS FOR PRODUCING SINGLE CRYSTAL CARBON FILMS**
VERFAHREN UND VORRICHTUNG ZUR HERSTELLUNG VON EINKRISTALLINEN SCHICHTEN AUS KOHLENSTOFF
PROCEDE ET APPAREIL POUR LA PRODUCTION DE COUCHES MONOCRISTALLINES EN CARBONE

(30) Priority: 14.02.1995 KZ 95010095
(43) Date of publication of application: 03.12.1997
(73) Proprietor: Kapparov, Kairat Kapparovich, Almaty, 480063 (KZ)
(72) Inventor: KAPPAROV, Kairat Kapparovich, Almaty, 480063 (KZ); OMAROV, Marat Akhmetovich, Almaty, 480035 (KZ)
(74) Representative: Patentanwälte Zellentin & Partner
(86) International application number: KZ9600001
(87) International publication number: WO9625537

(56) References cited:
- EP-A- 0 360 994
- EP-A- 0 617 147
- DE-A- 3 712 205
- PATENT ABSTRACTS OF JAPAN vol. 12, no. 291 (E-644), 9 August 1988 & JP,A,63 067720 (MEIDENSHA CO LTD), 26 March 1988,
- PATENT ABSTRACTS OF JAPAN vol. 12, no. 291 (E-644), 9 August 1988 & JP,A,63 067717 (MEIDENSHA CO LTD)

## Description

This invention pertain to a method of developing films, wich consists of carbon atoms used in treatment industries, optics (including X-ray) and electronics.

### BACKGROUND ART

The known way to get diamond films includes an electron radiation spray of solid carbon in a vacuum chamber, wich the follow-up separation of carbon steam and carbon ions precipitation on substrates, situated on electrodes-wafers.

The given method is used in equipment which contains an electron-radiation source, the latter heating the solid carbon block by a beam of electrons with the subsequent spray and separation (EP-A-0360994).

Sprayed carbon, consisting of positive, negative ions and neutral carbons atoms goes through the aperture of a restricting screen and is separated by a DC field which is perpendicular to the beam. The DC field, with the voltage of 100 V sm, is created by electrode wafers located behind the screen is such a way that the carbon steam column coming out of the screen aperture goes between the wafers. Simultaneously these wafers are the holders of silicon single-crystal substrates.

Using the above method produces only polycrystal diamond films, which is its main drawback. Besides, large quantities of power are needed to spray solid carbon by the beam of electrons. There are also methods of semiconductor carbon films producing in magnetic system with the use of high frequency (frequency ∼ 13,56 MHz), gas plasma and complex graphite target (JP-A-63067717 and JP-A-63067720). Electric discharge occur in gaseous mixture of H₂ and noble gases, pressure 1,33-665 Pa. The complex graphite target containing indium (In) or selenium (Se) makes possible to get carbon semiconductor films of n or p-type. Substrates on which the film were deposited fixed on substrates' holders placed on the internal chamber surface. These methods give amorphous In- or Se-doped carbon films with optic-energy gap from 2,5 eV up to 2,8 eV depending on dope's concentration.

The closed in technical essence to the claimed invention is the method of diamond crystal development by carbon sputtering on single crystal substrate with the use of high-frequency energy for the plasma formation (Patent EP-A-0617147).

In this method diamond crystal forms on single crystal substrate being under definite voltage in magnetic system with the use of high frequency field from 40 to 250 MHz. Graphite target's spraying occur in high-frequency gaseous discharge. Gaseous mixture consisting from hydrogen and noble gases is maintained in the discharging chamber under the pressure from 1 to 10⁴ Pa.

In noted method the diamond crystal formed on big area with good duplication. However the use of gaseous discharge for the films production inevitably will lead to the contamination of deposited films. It cause the presence of amorphous phase along with crystal diamond in films received by noted method.

The goal of this invention is to work out a method and the necessary equipment with which it is possible to get, in conditions of low pressure, single-crystal carbon films on single-crystal substrates.

The suggested invention also gives the possibility to obtain doped single-crystal carbon films having the properties of semiconductors.

### DISCLOSURE OF INVENTION

The objectives put are achieved through a new organization of the process of developing carbon films at low pressure and creating new arrangements for this process fulfillment. Carbon plasma is obtained by spraying a cathode - the target of solid carbon. The resulting plasma is sustained by carbon atoms, sprayed from the surface of cathode-target in a smouldering discharge with DC in a magnetron system. Then carbon ions are accelerated and precipitated on a single-crystal substrate.

Initially carbon atoms and electrons are knocked out by the positive ions of residual gas. After that, the electrons move from the cathode-target to anode ionize carbon atoms. Carbon ions in their turn knock out new carbon atoms and electrons from the surface of the cathode-target. Thus there appears the possibility to sustain carbon plasma in the conditions of smouldering discharge by carbon atoms, themselves. This makes it possible to get a uniform composition of carbon plasma, which is one of the main conditions of getting single-crystal carbon films. The suggested invention also makes it possible to increase single-crystal films growth rate by means of additional application of longitudinal magnetic field to the electric field. In this case, the length of the electron path increases, and the number of ionized carbon atoms grows with the increase of the density of carbon plasma.

Substrate heating in the process of carbon films growth makes it possible to bring down residual elastic tension in a single-crystal film.

Co-spraying of solid carbon together with the doped material makes it possible to get single-crystal films, having the properties of semi-conductors and in this way widen the sphere of single-crystal carbon film usage.

The claimed method of developing single-crystal films is performed with the help of new models of arrangements. The suggested arrangement has a vacuum chamber, cathode-target and an annular anode, all made of solid carbon and single-crystal substrate. It is marked by the fact that it has an additional cathode with an aperture for carbon ions flow and a magnet. It should be noted that the cathode with an aperture is between the anode and the substrate. Such location of the additional cathode makes it possible to extract positive carbon ions with the follow up acceleration from plasma consisting of electrons, carbon ions and carbon atoms. The magnet made of solid carbon, located behind the cathode-target, from the side, opposite to the annular anode. This makes it possible to increase the number of ionized carbon atoms due to electron path increase.

In order to increase the single-crystal films growth rate, the suggested arrangement is equipped by additional magnet, located above the substrate from the side opposite to the additional cathodes. This extra magnet is oriented towards the main one in such manner to from a longitudinal magnetic field.

It is also suggested to equip the arrangement with the doping unit, consisting of anode, magnet and cathode made of doping material and located between anode and magnet. It should be noted that the doping unit is arranged in such a way that there is the possibility to mix the flows of doping material ions and carbon. The presence of the doping unit and its location make it possible to get doped single-crystal carbon films having the properties of semiconductors.

Therefore in one embodiment the invention comprises a method for developing a single-crystal carbon film in a vacuum chamber at residual pressure in which carbon plasma in produced by a smouldering discharge between a target cathode of solid carbon (2) and an annular anode of solid carbon (4), located between the target cathode and an additional cathode of solid carbon having an aperture (5), said additional cathode being located between said anode and a single crystal substrate (6), in which electrons sprayed from the cathode target surface are directed by direct current in a magnetic system (3) towards the anode causing carbon ion acceleration due to the voltage between the annular anode and the additional cathode in such a way that carbon ions are precipitated on the single crystal substrate.

In a further embodiment the invention comprises an apparatus for the creation of a single-crystal carbon film comprising a vacuum chamber, a magnet, a cathode-target made of solid carbon and an annular anode made of solid carbon and a single-crystal substrate, characterized in that it contains an additional cathode of solid carbon with an aperture, located between the anode an the substrate, the magnet being located behind the cathode-target from the side opposite to the annular anode.

### BRIEF DESCRIPTION OF DRAWINGS

The invention is explained by the following drawing.

Fig.1 shows the arrangement from the claim 5 of the invention formula for the development of single-crystal substrate, which implements the suggested method according to claim 1 of the invention formula.

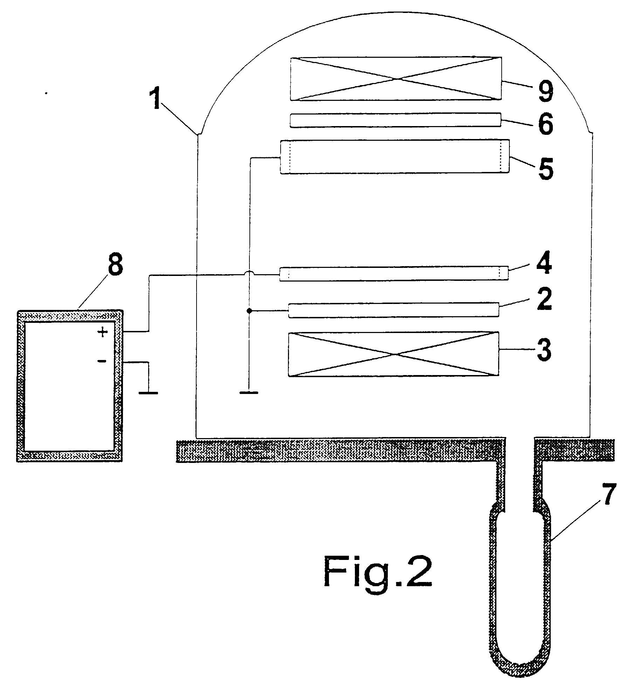

Fig.2 shows the arrangement according to claim 6 of the invention formula, implementing the method according to claim 2 of the formula.

Fig.3 shows the arrangement according to claim 7 of the formula which is used to implement the method of developing doped single-crystal carbon films according to claim 3 and 4 of the formula.

### MODES FOR CARRYING OUT THE INVENTION

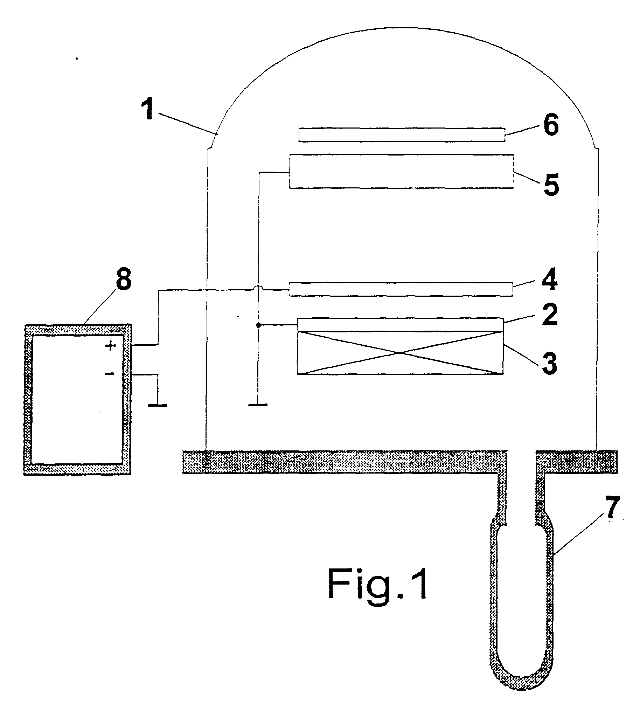

The suggested arrangement (Fig.1) has a vacuum chamber 1 with annular anode 4 made of solid carbon, and cathode-target 2 made of solid carbon, under which there is magnet 3. It is additionally equipped with cathode 5 made of solid carbon, over which there is substrate 6 of single-crystal material. Cathodes 2 and 5 connected with each other and have negative potential with respect to anode 4, located between them. The vacuum chamber is equipped by the pumping system 7. Voltage between the anode and the cathode is supplied from a DC source.

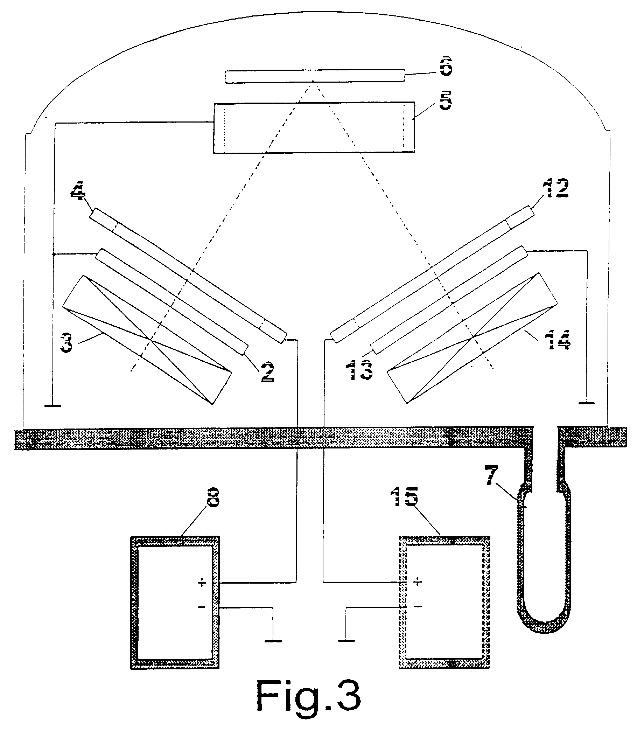

The arrangement, shown in Fig.3, is additionally equipped with the doping unit, consisting of anode 12, cathode 13 made of doping material and magnet 14. The doping unit is connected with power source 15. Cathode 13 is located between anode 12 and magnet 14. In this case the doping unit is arranged in such a way that there is a possibility to mix the ions of doping substance and carbon in the vicinity of substance 6.

The suggested arrangement operates in the following way. With the help of the pumping out system 7, certain residual pressure is achieved, which value depends on the type of carbon film (graphite, diamond and etc.). Then the voltage is applied from the source 8 to anode 4 there is a possibility to get smouldering discharge between cathode 2 and anode 4. By the choice of the distance between cathode and anode, it is possible to get stable, structurally uniform carbon plasma which is sustained by means of carbon atoms and electrons, knocked out from the surface of cathode-target 2. In this case electrons, moving from cathode 2 towards anode 4, ionize carbon atoms. By means of the magnetic field of magnet influence the run length of the electrons increases, and consequently, so the number of ionized carbon atoms does. Positive carbon ions, which reach the annular space of anode 4 due to their kinetic energy, are accelerated up towards cathode 5 by the electric field, existing between anode 4 and cathode 5. Having passed through the annular space of cathode 5, they attained the single-crystal substrate 6 where they precipitate and form single-crystal carbon film.

To increase the growth rate of single-crystal films, the arrangement is equipped with extra magnet 9, which form a magnetic field together with magnet 3. As a result, electron path increases still more which cause the increase of the number of positive carbon ions formed during the time unit per area unit.

In order to get doped single-crystal films the arrangement (Fig.3) is used, where the spraying of cathode 13, made of doped material, is done simultaneously with the spraying of cathode 2 made of solid carbon. Cathode 13 doping is performed in a way similar to cathode 2 doping in the regime of smouldering discharge. This smouldering discharge is obtained by applying voltage from the source of DC 15. The flow of carbon plasma and that of a doping substance get mixed in the vicinity of substrate 6 and precipitate on it, form doped single-crystal carbon film.

Example No 1. The process of developing single-crystal carbon film was carried out in vacuum chamber 1 under the pressure of 10⁻⁴ Pa. For that purpose, the arrangement, consisting of graphite cathode 2, annular graphite anode 4, substrate 6, made of single-crystal silicon wafer with orientation t (100), located behind the annular graphite cathode 5 and magnet 3, which is behind cathode 2 was used. Cathode 2 and cathode 4 are connected electrically with each other. Smouldering discharge was obtained from source 2 by applying voltage 5 kV between anode 4 and cathode 2 and 5. By choosing the distance between cathode 2 and 5 and anode 4, stable uniform carbon plasma of smouldering discharge was developed. The process of graphite cathode 2 doping in smouldering discharge and carbon ion precipitation on carbon substrate 6 resulted in single-crystal carbon film formation.

Investigation of the films by X-ray structural analyses showed, that obtained the films are single-crystal and have the structure of a diamond with surface orientation (111). Specific resistance of the resulting single-crystal carbon films was ρ=10¹² Ohm m. The films microhardness (according to Moos) is 1, which corresponds to diamond microhardness . When bringing residual pressure up to 10⁻² Pa and correspondingly bringing down voltage to 500 V. single-crystal graphite film was obtained on the substrate.

In example 2 the arrangement similar to the one described in example 1 was used. The difference was that the arrangement was equipped with additional magnet 9 to create the longitudinal magnetic field in the arrangement. This longitudinal magnetic field contribute to the density increase of the plasma, which made it possible to bring down voltage, sustaining 5 kV up and 3 kV at constant distances between cathode and anode. The results of the samples investigation showed, that the presence of additional magnet 9 did not have any obvious influence on the films single-crystallinity. Thus, in example 1, the growth rate was 100Å per hour while in example 2, growth rate increased up to 1000Å per hour with the rest of the parameters remaining constant.

Example 3. Single-crystal doped film are developed in the arrangement similar to the one described in example 2 with the extra doping unit. The doping unit cathode was made of boron oxide. When the voltage of 1,5 kV was applied to anode 12, it was possible to achieve stable plasma consisting of doping material (boron). By mixing the latter with the flow of carbon plasma and by precipitation of the mixed flow on silicon substrate, carbon films doped by boron, having the property of semiconductors of R-type, were obtained. Specific resistance of these semi-conductors was up ρ=10⁴ Ohm m.

From the example given above, it is obvious that the invention suggested ensures the possibility of getting single-crystal carbon films on single-crystal silicon substrates.

The films produced in this way may be used in electronics, and in the jewelry industry, including X-ray structure investigation monochromators.

## Claims

1. A method for developing a single-crystal carbon film in a vacuum chamber at residual pressure in which carbon plasma is produced by a smouldering discharge between a target cathode of solid carbon (2) and an annular anode of solid carbon (4), located between the target cathode and an additional cathode of solid carbon having an aperture (5), said additional cathode being located between said anode and a single crystal substrate (6), in which electrons sprayed from the cathode target surface are directed by direct current in a magnetic system (3) towards the anode causing carbon ion acceleration due to the voltage between the annular anode and the additional cathode in such a way that carbon ions are precipitated on the single crystal substrate.

2. A method, in accordance with claim 1 in which to the electron field is additionally applied to longitudinal magnetic field.

3. A method in accordance with claim 1 or 2 in which the spraying of cathode-target of solid carbon is done in the presence of dopping mixture.

4. A method in accordance with claim 3 in which the spraying of the cathode-target of solid carbon is done simultaneously with the dopping mixture spraying.

5. An apparatus for the creation of a single-crystal carbon film comprising a vacuum chamber, a magnet, a cathode-target made of solid carbon and an annular anode made of solid carbon and a single-crystal substrate, characterized in that it contains an additional cathode of solid carbon with an aperture, located between the anode and the substrate, the magnet being located behind the cathode-target from the side opposite to the annular anode.

6. An apparatus in accordance with claim 5 in which it is additionally equipped by additional magnet located over the substrate from the side opposite to additional cathode with possibility to form longitudinal field.

7. An apparatus in accordance with claim 5 or 6 it is additionally equipped by doping unit consisting of a magnet anode and cathode made of doping material and located between anode and magnet, placed so that there is the possibility to mix ion flows of doping material and carbon.

## Patentansprüche

1. Verfahren zum Herstellen einer einkristallinen Schicht aus Kohlenstoff in einer Vakuumkammer bei Restdruck, bei dem ein Kohlenstoffplasma durch Glimmentladung hergestellt wird zwischen einer Zerstäubungskathode (2) aus Homogenkohle und einer Ringanode (4) aus Homogenkohle, die zwischen der Zerstäubungskathode und einer zusätzlichen, eine Öffnung aufweisenden Kathode (5) aus Homogenkohle angeordnet ist, wobei die zusätzliche Kathode zwischen der Anode und einem Einkristallsubstrat (6) angeordnet ist, und bei dem Elektronen, die von der Oberfläche der Zerstäubungskathode gesprüht werden, durch Gleichstrom in einem Magnetsystem (3) gegen die Anode gelenkt werden, wodurch eine Kohlenstoffionenbeschleunigung aufgrund der Spannung zwischen der Ringanode und der zusätzlichen Kathode in einer solchen Weise erzeugt wird, daß Kohlenstoffionen auf dem Einkristallsubstrat abgeschieden werden.

2. Verfahren nach Anspruch 1, bei dem zu dem Elektronenfeld zusätzlich ein longitudinales Magnetfeld aufgebracht wird.

3. Verfahren nach Anspruch 1 oder 2, bei dem das Sprühen der Zerstäubungskathode aus Homogenkohle in Gegenwart einer Dotiermischung vorgenommen wird.

4. Verfahren nach Anspruch 3, bei dem das Sprühen der Zerstäubungskathode aus Homogenkohle gleichzeitig mit dem Sprühen der Dotiermischung vorgenommen wird.

5. Vorrichtung zum Herstellen einer einkristallinen Schicht aus Kohlenstoff mit einer Vakuumkammer, einem Magneten, einer Zerstäubungskathode aus Homogenkohle und einer Ringanode aus Homogenkohle und einem einkristallinen Substrat, dadurch gekennzeichnet, daß sie eine zusätzliche, eine Öffnung aufweisende Kathode aus Homogenkohle enthält, die zwischen der Anode und dem Substrat angeordnet ist, wobei der Magnet hinter der Zerstäubungskathode auf der von der Ringanode abgewandten Seite angeordnet ist.

6. Vorrichtung nach Anspruch 5, die zusätzlich mit einem zusätzlichen Magneten ausgestattet ist, der über dem Substrat auf der von der zusätzlichen Kathode abgewandten Seite mit der Möglichkeit der Bildung eines longitudinalen Feldes angeordnet ist.

7. Vorrichtung nach Anspruch 5 oder 6, die zusätzlich mit einer Dotiereinheit ausgestattet ist, die einen Magneten, eine Anode und eine Kathode aufweist, die aus Dotiermaterial hergestellt ist und zwischen der Anode und dem Magneten derart angeordnet ist, daß die Möglichkeit besteht, Ionenströme aus Dotiermaterial und Kohlenstoff zu mischen.

## Revendications

1. Procédé pour développer un film de carbone monocristallin dans une chambre à vide sous une pression résiduelle, dans laquelle un plasma au carbone est produit par une décharge couvante entre une cathode cible de carbone solide (2) et une anode annulaire de carbone solide (4), située entre la cathode cible et une cathode additionnelle de carbone solide ayant une ouverture (5), ladite cathode additionnelle étant située entre ladite anode et un substrat monocristallin (6), dans lequel des électrons pulvérisés à partir de la surface cible de cathode sont dirigés par un courant continu dans un système magnétique (3) en direction de l'anode, provoquant une accélération des ions carbone due à la tension entre l'anode annulaire et la cathode additionnelle de telle sorte que les ions carbone soient précipités sur le substrat monocristallin.

2. Procédé selon la revendication 1, dans lequel au champ d'electrons est de plus appliqué un champ magnétique longitudinal.

3. Procédé selon la revendication 1 ou 2, dans lequel la pulvérisation sur la cible formant cathode du carbone solide est effectuée en présence d'un mélange dopant.

4. Procédé selon la revendication 3, dans lequel la pulvérisation sur la cible formant cathode de carbone solide est réalisée simultanément à la pulvérisation du mélange dopant.

5. Appareil pour la création d'un film de carbone monocristallin, comprenant une chambre à vide, un aimant, une cible formant cathode faite en carbone solide et une anode annulaire faite en carbone solide et un substrat monocristallin, caractérisé en ce qu'il contient une cathode additionnelle de carbone solide avec une ouverture, située entre l'anode et le substrat, l'aimant étant situé sous la cible de cathode depuis le côté opposé à l'anode annulaire.

6. Appareil selon la revendication 5, qui est de plus équipé d'un aimant additionnel situé au-dessus du substrat en partant du côté opposé à la cathode additionnelle, avec possibilité de formation d'un champ longitudinal.

7. Appareil selon la revendication 5 ou 6, qui est de plus équipé d'une unité de dopage constituée d'une aimant, d'une anode et d'une cathode, faite en matériau dopant et située entre l'anode et l'aimant, placée de telle sorte qu'il y ait une possibilité de mélange les flux d'ions de matériau dopant et de carbone.
